(19) Europäisches Patentamt
European Patent Office
Office européen des brevets

(11) EP 2 697 632 B1

(12) **FASCICULE DE BREVET EUROPEEN**

(45) Date de publication et mention de la délivrance du brevet:
**09.05.2018 Bulletin 2018/19**

(21) Numéro de dépôt: **12719994.1**

(22) Date de dépôt: **13.04.2012**

(51) Int Cl.:
***G01N 25/00*** *(2006.01)* ***G01N 27/04*** *(2006.01)*
***H01L 21/66*** *(2006.01)*

(86) Numéro de dépôt international:
**PCT/FR2012/000144**

(87) Numéro de publication internationale:
**WO 2012/140340 (18.10.2012 Gazette 2012/42)**

(54) **PROCEDE DE DETERMINATION DE LA CONCENTRATION EN OXYGENE INTERSTITIEL**

VERFAHREN ZUR BESTIMMUNG DER INTERSTITIELLEN SAUERSTOFFKONZENTRATION

METHOD FOR DETERMINING INTERSTITIAL OXYGEN CONCENTRATION

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **15.04.2011 FR 1101190**

(43) Date de publication de la demande:
**19.02.2014 Bulletin 2014/08**

(73) Titulaire: **Commissariat à l'Énergie Atomique et aux Énergies Alternatives**
**75015 Paris (FR)**

(72) Inventeurs:
- **VEIRMAN, Jordi**
  **74330 Poisy (FR)**
- **DUBOIS, Sébastien**
  **74950 Scionzier (FR)**
- **ENJALBERT, Nicolas**
  **81100 Burlats (FR)**

(74) Mandataire: **Talbot, Alexandre et al**
**Cabinet Hecké**
**28 Cours Jean Jaurès**
**38000 Grenoble (FR)**

(56) Documents cités:
**FR-A1- 2 460 479 US-A- 5 287 167**

- **SIMOEN E ET AL: "Characterisation of oxygen and oxygen-related defects in highly- and lowly-doped silicon", MATERIALS SCIENCE AND ENGINEERING B, ELSEVIER SEQUOIA, LAUSANNE, CH, vol. 102, no. 1-3, 15 septembre 2003 (2003-09-15), pages 207-212, XP004450731, ISSN: 0921-5107, DOI: 10.1016/S0921-5107(02)00706-7**
- **RAVA P ET AL: "THERMALLY ACTIVATED OXYGEN DONORS IN SI", JOURNAL OF THE ELECTROCHEMICAL SOCIETY, ELECTROCHEMICAL SOCIETY. MANCHESTER, NEW HAMPSHIRE, US, vol. 129, no. 12, 1 décembre 1982 (1982-12-01), pages 2844-2849, XP000840673, ISSN: 0013-4651**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).



Printed by Jouve, 75001 PARIS (FR)

## Description

### Domaine technique de l'invention

L'invention est relative à un procédé permettant de déterminer la concentration en oxygène interstitiel d'un échantillon semi-conducteur dopé de type p.

### État de la technique

Les substrats en silicium destinés à l'industrie microélectronique ou aux applications photovoltaïques comprennent de l'oxygène. Lorsqu'ils ne sont pas sous forme de précipités, les atomes d'oxygène occupent généralement des positions interstitielles dans le réseau cristallin. Dans le cas du silicium monocristallin, obtenu par le procédé Czochralski, ou dans le cas du silicium polycristallin de qualité dite « solaire », la concentration en oxygène interstitiel varie entre $10^{17}$ et $2.10^{18}$ atomes/$cm^3$.

L'oxygène en position interstitielle ($O_i$) joue un rôle important sur les propriétés mécaniques et électriques du silicium. En particulier, à des températures comprises entre 200 °C et 500 °C, l'oxygène forme des précipités appelés Doubles Donneurs Thermiques (DDT) qui modifient les propriétés électriques du matériau. A plus haute température, l'oxygène forme d'autres précipités permettant de piéger des impuretés métalliques présentes dans le silicium. Un effet getter peut ainsi être obtenu. Par ailleurs, l'oxygène améliore les propriétés mécaniques des substrats en bloquant les dislocations introduites par les procédés de fabrication.

Pour les applications photovoltaïques, une concentration en oxygène élevée entraîne une diminution des performances sous éclairement, notamment une diminution du rendement de conversion des cellules photovoltaïques à base de silicium dopé au bore (B).

Il paraît donc important de connaître la concentration et la répartition de l'oxygène interstitiel au sein du substrat pour déterminer localement l'influence de l'oxygène sur les propriétés électriques et mécaniques du silicium. Ces informations permettent ensuite d'optimiser les procédés de cristallisation ou de fabrication des dispositifs.

La concentration en oxygène d'un échantillon est classiquement déterminée par spectroscopie infrarouge FTIR (« Fourier Transform InfraRed spectroscopy »). Cependant, cette technique est lente et imprécise. Par ailleurs, elle nécessite un échantillon d'au moins 200 $\mu$m d'épaisseur et une préparation de la surface de l'échantillon.

L'article « Characterization of the oxygen distribution in Czochralski silicon using hydrogen-enhanced thermal donor formation » (A.G. Ulyashin et al., Materials Science and Engineering B73 124-129, 2000) décrit une autre technique de détermination de la concentration en oxygène.

Cette technique est basée sur la formation de donneurs thermiques DDT. Un traitement thermique assisté par un plasma hydrogène est appliqué à un échantillon de type P de manière à former une jonction PN. Puis, la profondeur de la jonction PN dans l'échantillon est déterminée à l'aide de mesures de résistance de type SRP (« Spreading Résistance Probe » en anglais) ou de mesures de capacité C-V (« Capacitance-Voltage » en anglais). La concentration en donneurs thermiques est ensuite calculée à partir de la profondeur de la jonction PN. Un modèle mathématique permet de déterminer la concentration en oxygène à partir de la concentration en donneurs thermiques.

Les méthodes de caractérisation employées requièrent, au même titre que la FTIR, une préparation de l'échantillon. La caractérisation SRP nécessite de biseauter l'échantillon pour établir le profil de résistance sur la profondeur de l'échantillon. La caractérisation C-V utilise des contacts métalliques à la surface de l'échantillon. Ces contacts sont difficiles à enlever sans dégrader ou polluer le matériau de l'échantillon.

En raison de la complexité de ces méthodes de caractérisation, la technique de mesure de l'article susmentionné est lente et difficilement applicable à des substrats de l'industrie microélectronique et photovoltaïque.

De plus, la préparation et l'hydrogénation du substrat rendent celui-ci inutilisable à l'issue de la mesure.

Par ailleurs, la demande de brevet FR 246479 décrit un procédé de caractérisation de la teneur en oxygène d'un barreau de silicium tiré selon la méthode de Czochralski. Ce procédé a pour but d'écarter les plaques ayant une teneur en oxygène en dehors des spécifications requises. Le procédé de caractérisation comporte une mesure de résistivité effectuée sur une portion du barreau, après un recuit de stabilisation. La portion est ensuite soumise à un recuit entre 650 et 850 °C, puis la résistivité est à nouveau mesurée. Enfin, la variation de la résistivité, correspondant à une génération de donneurs thermiques, est comparée à un seuil représentatif de la concentration initiale en oxygène.

### Résumé de l'invention

On constate qu'il existe un besoin de prévoir un procédé rapide et simple à mettre en oeuvre permettant de déterminer la concentration en oxygène interstitiel d'un échantillon en matériau semi-conducteur du groupe IV et de type p.

L'échantillon comprenant des impuretés dopantes de type accepteur et présentant une concentration initiale en porteurs de charge et une résistivité initiale, on tend à satisfaire ce besoin par les étapes suivantes :

a) soumettre l'échantillon à un traitement thermique pour former des donneurs thermiques constituant des impuretés dopantes de type donneur ;

b) déterminer la durée du traitement thermique nécessaire pour obtenir un matériau semi-conducteur compensé en impuretés dopantes ;

c) déterminer la concentration en donneurs thermiques de l'échantillon en matériau semi-conducteur compensé, à partir de la concentration en porteurs de charge ; et

d) déterminer la concentration en oxygène interstitiel à partir de la concentration en donneurs thermiques et de la durée du traitement thermique.

On prévoit en outre, après la détermination de la concentration en oxygène interstitiel, une étape de traitement thermique à une température supérieure ou égale à 650°C afin de restituer l'échantillon dans son état initial.

**Description sommaire des dessins**

D'autres avantages et caractéristiques ressortiront plus clairement de la description qui va suivre de modes particuliers de réalisation donnés à titre d'exemples non limitatifs et illustrés à l'aide des dessins annexés, dans lesquels :

- la figure 1 représente des étapes d'un procédé de détermination de la concentration en oxygène interstitiel $C_o$ selon l'invention ;
- la figure 2 représente un mode de mise en oeuvre de l'étape de recuit F1 selon la figure 1 ;
- la figure 3 représente une variante de mise en oeuvre de l'étape de recuit F1 selon la figure 1 ;
- la figure 4 représente des abaques de la concentration en donneurs thermiques $N_{DDT}$ en fonction de la durée du recuit t, pour différentes valeurs de la concentration en oxygène interstitiel $C_o$ ; et
- la figure 5 représente des étapes supplémentaires du procédé de détermination de la concentration en oxygène interstitiel $C_o$ de la figure 1.

**Description d'un mode de réalisation préféré de l'invention**

Dans un substrat en silicium dopé de type p, les porteurs de charge libres sont des trous. Leur nombre dépend de la concentration $N_A$ d'impuretés dopantes implantées dans le silicium, généralement des atomes de bore (B). Ces atomes sont appelés accepteurs d'électrons.

Lorsque que le substrat est dopé essentiellement au bore, la concentration en trous $p_0$ est égale à la concentration en bore : $p_0 = N_A = [B]$.

Lorsque que le substrat comprend en outre des atomes donneurs d'électrons (par exemple de phosphore), en concentration $N_D$ non négligeable, la concentration initiale en trous libres $p_0$ est égale à la concentration en atomes accepteurs $N_A$ moins la concentration en atomes donneurs $N_D$ : $p_0 = N_A - N_D$. Cette relation est valable si les atomes accepteurs et donneurs sont ionisés une seule fois. Pour des atomes donneurs et/ou accepteurs ionisés plusieurs fois, on appliquera des degrés d'ionisation aux concentrations $N_A$ et/ou $N_D$ ($p_0 = \alpha N_A - \beta N_D$).

En soumettant le substrat à une température comprise entre 200 °C et 500 °C, des donneurs thermiques DDT sont formés dans le substrat. Les donneurs thermiques génèrent des électrons. Ils sont donc considérés comme des impuretés dopantes de type donneur. Les donneurs thermiques sont des donneurs doubles car chaque DDT génère deux électrons libres.

Lorsque la concentration en impuretés dopantes de type accepteur est sensiblement égale à la somme des concentrations en impuretés dopantes de type donneur (atomes de phosphore et donneurs thermiques), avec des concentrations pondérées le cas échant par les degrés d'ionisation, le substrat est dit compensé en impuretés dopantes. Cet état d'équilibre correspond en fait à la transition entre un substrat dopé de type p (trous majoritaires) et un substrat dopé de type n (électrons majoritaires).

On propose ici de détecter cet état d'équilibre lors du recuit, pour calculer de façon simple la concentration en donneurs thermiques $N_{DDT}$ puis en déduire la concentration en oxygène interstitiel $C_o$.

La figure 1 représente des étapes F1 à F3 d'un procédé de détermination de la concentration en oxygène interstitiel $C_o$ d'un échantillon semi-conducteur de type p.

Lors d'une première étape F1, un échantillon contenant de l'oxygène, par exemple un substrat en silicium, est soumis à un traitement thermique, ou recuit, pour former des donneurs thermiques. La température du recuit est, de préférence, comprise entre 200 °C et 500 °C, avantageusement entre 350 °C et 500 °C. En effet, comme cela sera décrit plus loin, la cinétique de formation des donneurs thermiques est bien connue dans cette plage de températures, notamment à 450 °C.

Lors du recuit, on relève la durée du recuit t pour laquelle le substrat de silicium est compensé. Plusieurs techniques permettant de détecter l'état compensé du silicium sont détaillées ci-après.

Une première technique consiste à mesurer la résistivité ρ du substrat pendant le recuit.

On constate que la résistivité augmente au fur et à mesure que des donneurs thermiques sont générés. Cela est dû au fait que les électrons issus des donneurs thermiques compensent les trous du substrat. Ainsi, le nombre de porteurs de charge tend vers zéro. Une fois la compensation atteinte, la résistivité diminue car le nombre de porteurs de charge (les électrons) augmente.

Ainsi, l'état compensé du silicium correspond à un maximum de la résistivité. Le silicium peut alors être considéré comme compensé lorsque la résistivité dépasse une valeur seuil, de préférence supérieure à 200 Ω.cm et supérieure à deux fois la résistivité initiale $\rho_o$ de l'échantillon, c'est-à-dire deux fois la résistivité avant le recuit de formation des donneurs thermiques.

La mesure de résistivité peut être réalisée de façon simple par la méthode des quatre pointes ou par une méthode sans contact, par exemple par couplage inductif.

Une deuxième technique consiste à détecter le changement du type de conductivité du substrat (le passage du type p au type n), en mesurant à plusieurs reprises le type de conductivité.

La détermination du type de conductivité repose sur la méthode de mesure du potentiel de surface (SPV, « surface photo voltage » en anglais). Le principe d'une telle mesure est le suivant. Un laser est appliqué périodiquement sur la surface du substrat, ce qui va générer temporairement des paires d'électron-trou. Le couplage capacitif entre la surface et une sonde permet de déterminer le potentiel de surface.

La différence entre le potentiel de surface sous éclairement et le potentiel de surface sous obscurité, et plus particulièrement le signe de cette différence, permet de déterminer le type de conductivité de l'échantillon. La mesure du type de conductivité par la méthode SPV est, par exemple, réalisée au moyen de l'équipement PN-100 commercialisé par la société SEMILAB.

La figure 2 représente un mode de mise en oeuvre de l'étape de recuit F1 de la figure 1. Le recuit est réalisé en plusieurs étapes jusqu'à ce que la résistivité du substrat atteigne ou dépasse un seuil prédéterminé. Un indice i, initialement nul, est utilisé pour compter ces étapes.

Dans une étape F11, on effectue le recuit pendant une période $t_i$. Puis, lors d'une étape F12, la résistivité ρ est mesurée. En F13, on compare la valeur mesurée de la résistivité à un seuil $\rho_m$ représentatif de l'état compensé. Si la résistivité mesurée ρ est inférieure au seuil $\rho_m$ (sortie NON de F13), on reboucle sur l'étape F11 et l'indice i est incrémenté. On effectue alors une nouvelle étape de recuit pendant une période $t_{i+1}$. La période de temps $t_{i+1}$ peut d'ailleurs être différente de la période $t_i$. Si la résistivité mesurée ρ est supérieure au seuil $\rho_m$ (sortie OUI de F13), la durée totale t de recuit appliqué au substrat est calculée en F14, en sommant les périodes de temps $t_i$ ($t = \sum_{i=0}^{n} t_i$).

La figure 3 représente une variante de mise en oeuvre des étapes F12 et F13 de la figure 2. Plutôt que de mesurer la résistivité, on mesure en F12 le type de conductivité, de préférence par la méthode SPV. Tant que la conductivité du substrat est de type p (sortie NON de F13), on répète les étapes F11 et F12. Par contre, dès que la conductivité passe du type p au type n (sortie OUI de F13), on calcule la durée cumulée t de recuit (F14).

L'étape F2 du procédé de la figure 1 consiste à calculer la concentration en donneurs thermiques $N_{DDT}$ du silicium compensé, à partir de la concentration initiale en porteurs de charge $p_0$. Pour cela, on exploite le fait que, dans le silicium compensé, la concentration d'impuretés de type accepteur est égale à la somme des concentrations en impuretés dopantes de type donneur (pondérées par leurs degrés d'ionisation respectifs).

Les impuretés de type donneur correspondent ici aux donneurs thermiques DDT et éventuellement aux atomes donneurs $N_D$, par exemple de phosphore, initialement présents dans le substrat. Ainsi, dans le cas le plus fréquent où les atomes donneurs ($N_D$) et accepteurs ($N_A$) sont ionisés une seule fois, on obtient :

$$2N_{DDT} + N_D = N_A \qquad (1).$$

Les donneurs thermiques comptent double car ils sont doublement ionisés.

La concentration initiale en porteurs de charge $p_0$ valant dans ce cas $N_A$ - $N_D$, l'équation (1) devient :

$$N_{DDT} = \frac{N_A - N_D}{2} = \frac{p_0}{2} \quad (2).$$

L'équation (2) permet ainsi de calculer la concentration en donneurs thermiques $N_{DDT}$ obtenue après un recuit d'une durée t, en connaissant la concentration initiale en porteurs de charge $p_0$ du substrat.

Ainsi, pour le calcul de la concentration en donneurs thermiques $N_{DDT}$, on utilisera la relation (2) qui reflète la compensation optimale. Dans la pratique, cet état d'équilibre est difficile à atteindre lors du recuit. Ainsi, pour déterminer la durée t de recuit, on considère que le silicium est compensé lorsque la concentration d'électrons générés par les donneurs thermiques ($2.N_{DDT}$) est égale à la concentration initiale en trous $p_0$ ($p_0 = \alpha N_A - \beta N_D$), avec une précision de l'ordre de ± 20 %.

En d'autres termes, on considère que l'état compensé est atteint lorsque l'équation suivante est satisfaite :

$$0{,}8 \times p_0 \leq 2N_{DDT} \leq 1{,}20 \times p_0$$

Avec cette approximation, la valeur de la durée de recuit t relevée à l'étape F1 est néanmoins proche de celle correspondant à la compensation optimale.

A l'étape F3, on détermine la concentration en oxygène interstitiel $C_o$ à partir de la durée du recuit t déterminée à l'étape F1 et de la concentration en donneurs thermiques $N_{DDT}$ calculée à l'étape F2.

La concentration en oxygène interstitiel $C_o$ est, de préférence, calculée à l'aide d'une relation tirée de l'article « Formation kinetics of oxygen thermal donors in silicon » (Wijaranakula C.A. et al., Appl. Phys. Lett. 59 (13), pp. 1608, 1991). Cet article décrit la cinétique de formation des donneurs thermiques dans le silicium par un recuit à 450 °C.

Cette température constitue d'ailleurs un bon compromis entre la vitesse de formation des donneurs thermiques et la concentration maximale obtenue. Une température supérieure à 450 °C favorise la vitesse de formation des DDT au détriment de la concentration maximale. Une température élevée est donc à privilégier lorsque l'on suppose que la concentration en oxygène est importante, par exemple supérieure à $5.10^{17}cm^{-3}$. A l'inverse, une température inférieure à 450 °C permettra d'augmenter la concentration maximale de DDT et pourra être utilisée pour des substrats dont la concentration approximative en oxygène est faible, par exemple inférieure à $5.10^{17}$ $cm^{-3}$.

Sans informations préalables sur la concentration en oxygène, on choisira, de préférence, une température de recuit égale à 450 °C.

La relation exprimant la concentration en donneurs thermiques $N_{DDT}$ en fonction de la concentration en oxygène $C_o$ et de la durée de recuit t est donnée ci-dessous :

$$N_{DDT}(t,C_o) = 4{,}51.10^{-52} \times \left( C_o \left[ 1 + \frac{2}{3} D_o \times t \times C_o^{\,2/3} \right]^{-3/2} \right)^{3{,}45} \times t^{1{,}02} \quad (3),$$

2,53 avec $D_o$ le coefficient de diffusion de l'oxygène interstitiel $(D_o = 0{,}13 \times e^{-\frac{2{,}53}{kT}})$.

Connaissant t et $N_{DDT}$, on peut calculer facilement la concentration en oxygène interstitiel $C_o$ du substrat.

Alternativement, la concentration en oxygène interstitiel $C_o$ peut être déterminée à l'aide d'abaques de la concentration en donneurs thermiques $N_{DDT}$ en fonction de la durée de recuit t, pour différentes valeurs de la concentration en oxygène $C_o$.

La figure 4 représente l'un de ces abaques, construit à partir de la relation (3) et pour une température de recuit de l'ordre de 450°C.

On peut remarquer qu'une faible variation de la concentration en oxygène $C_o$ conduit à une forte variation de la concentration en donneurs thermiques $N_{DDT}$. A titre d'exemple, au bout d'une heure de recuit, un substrat de concentration en oxygène égale à $5.10^{17}$ $cm^{-3}$ forme $2{,}5.10^{13}$ DDT par $cm^{-3}$, alors qu'un substrat avec une concentration en oxygène trois fois supérieure forme environ 100 fois plus de donneurs thermiques.

L'abaque de la figure 4 permet de déterminer la valeur de la concentration en oxygène $C_o$ dans la zone du substrat mesurée, pour une concentration $N_{DDT}$ et une durée de recuit t données.

Pour une température de recuit différente de 450 °C, la relation (3) et les abaques peuvent être adaptés notamment grâce aux enseignements de l'article « Effect of oxygen concentration on the kinetics of thermal donor formation in silicon at temperatures between 350 and 500 °C » (Londos C.A. et al., Appl. Phys. Lett. 62 (13), pp. 1525, 1993). Cet article décrit également la cinétique de formation des donneurs thermiques dans le silicium, mais pour des températures de recuit comprises entre 350 °C et 500 °C.

Le calcul de $N_{DDT}$ réalisé à l'étape F2 nécessite de connaître la valeur de la concentration en porteurs de charge $p_0$. Cette valeur est généralement donnée par le fournisseur des substrats. Dans le cas contraire, elle peut être déterminée lors d'une étape supplémentaire du procédé de la figure 1.

La figure 5 représente des étapes supplémentaires du procédé de détermination, dont une permet de déterminer la concentration en porteurs de charge $p_0$.

Lorsque la concentration $p_0$ est inconnue, on peut réaliser, avant de procéder au recuit, une mesure de la résistivité initiale $\rho_o$ du substrat lors d'une étape F0'. Cette mesure permet ensuite de calculer la concentration en porteurs de charge (trous) $p_0$, grâce à la relation suivante :

$$\rho_0 = \frac{1}{q \times p_o \times \mu_P} \qquad (4),$$

q étant la charge élémentaire ($q = 1{,}6.10^{-19}$ C) et $\mu_p$ la mobilité des trous dans le silicium.

Cette relation n'est valable que lorsque le substrat comprend essentiellement des atomes accepteurs ($p_0$=$N_A$), c'est-à-dire lorsque la concentration initiale en atomes donneurs $N_D$ est nulle ou négligée. On considère que la concentration initiale en atomes donneurs $N_D$ est négligeable lorsque celle-ci est inférieure à un cinquième de la concentration en impuretés dopantes de type accepteur $N_A$ ($N_D \leq 1/5.N_A$ ou $5.N_D \leq N_A$).

Si le substrat présente initialement les deux types de dopants, donneurs et accepteurs ($p_0$=$N_A$-$N_D$), avec une concentration $N_D$ supérieure à un cinquième de la concentration $N_A$ ($5.N_D \geq N_A$), alors on détermine $p_0$ avec d'autres méthodes, comme les mesures par effet Hall ou la spectrométrie d'absorption.

Afin de s'assurer que le substrat ne comporte pas de donneurs thermiques dans son état initial, ce qui pourrait fausser la valeur de $p_0$, on procède, de préférence, à un recuit, en F0, à une température supérieure ou égale à 650 °C. Cela rend les précipités d'oxygène (ou donneurs thermiques DDT) instables et les élimine. Les atomes d'oxygène reprennent alors leurs positions interstitielles. Les mesures de $p_o$ et $\rho_o$ sont donc réalisées après un tel recuit.

Le recuit F0 peut d'ailleurs être réalisé même lorsque la concentration $p_o$ est connue, afin de s'assurer que la concentration en donneurs thermiques $N_{DDT}$ est initialement nulle.

Un tel recuit est, de préférence, également utilisé à la fin du procédé, en F4, après avoir déterminé la concentration en oxygène interstitiel dans la zone souhaitée (F3). Grâce à cette étape de recuit F4, le substrat revient dans son état initial et peut être réutilisé.

A titre d'exemple, un recuit de dissociation des donneurs thermiques (F0), à 650 °C pendant 30 min, est appliqué à une plaquette de silicium dopée au bore. La résistivité de la plaquette, mesurée par la méthode des quatre pointes (F0'), est environ égale à 18,8 Q.cm, ce qui correspond à une concentration initiale en trous $p_0$ (ou une concentration en bore $N_A$) de l'ordre de $7{,}2.10^{14}$ $cm^{-3}$ (équation (4) : le matériau présente une faible concentration en atomes donneurs : $N_D < 10^{13}$ $cm^{-3}$).

La plaquette est ensuite soumise à plusieurs étapes de recuit (F11) à 450 °C, de 15 minutes chacune, jusqu'à ce que le silicium soit compensé. Le type de conductivité (Fig.3 ; F12) est mesurée après chaque étape de recuit par la méthode SPV, à l'aide de l'équipement PN-100 de la société SEMILAB.

La durée totale de recuit pour obtenir le silicium compensé s'élève à 4,5 heures. Ainsi, au bout de 4,5 heures de recuit, la concentration en donneurs thermiques $N_{DDT}$ de la plaquette vaut $3{,}6.10^{14}$ $cm^{-3}$ ($p_0/2$). La concentration en oxygène interstitiel, calculée à partir de la relation (3), est égale à $7.10^{17}$ $cm^{-3}$, en accord avec la valeur obtenue par FTIR (entre $6.10^{17}$ $cm^{-3}$ et $9.10^{17}$ $cm^{-3}$).

Le procédé de détermination représenté à la figure 1 est rapide et facile à mettre en oeuvre car il met en oeuvre des techniques de caractérisation simples. En outre, il dispose d'une bonne de précision, de l'ordre de 5 % sur la valeur de la concentration en oxygène interstitiel $C_0$.

Le procédé peut avantageusement être appliqué en plusieurs zones du substrat, de manière à constituer une cartographie complète de celui-ci. On associe alors, à chaque zone du substrat, la durée de recuit t pour laquelle la zone est compensée et la concentration en donneurs thermiques $N_{DDT}$ associée ($N_{DDT} = p_0/2$). Puis, on calcule la concentration en oxygène interstitiel à partir du couple de valeur (t, $N_{DDT}$) pour chaque zone du substrat. Une telle cartographie peut ensuite être utilisée pour optimiser la fabrication de dispositifs.

La concentration en donneurs thermiques $N_{DDT}$ peut être déterminée par une étape de calcul à partir de la concentration initiale en porteurs de charge $p_0$, comme cela a été décrit précédemment. Toutefois, d'autres techniques peuvent être utilisées, notamment une technique qui détermine la concentration $N_{DDT}$ à partir de la concentration en porteurs de charge de l'échantillon, mesurée après l'étape de recuit (et non plus avant). Cette technique est la suivante.

Dans une variante de réalisation de l'étape F2, la concentration en donneurs thermiques $N_{DDT}$ du silicium compensé est déterminée à partir de la concentration en porteurs de charge mesurée immédiatement après que l'échantillon ait changé de type de conductivité.

La concentration en porteurs de charge après le passage du type p au type n est notée ci-après $n_0$. Elle est mesurée pour plusieurs températures T de l'échantillon, par exemple par effet Hall. On obtient alors une courbe expérimentale $n_0(T)$ à partir de ces mesures en température.

Les expressions théoriques de $n_0$ en fonction de la température sont les suivantes :

$$n_0(T) = \frac{N_D}{1 + 2\exp\left(\frac{E_F - E_D}{kT}\right)} + N_{DDT} \cdot \frac{\beta(T) \cdot (1 + 2 \cdot \alpha(T))}{1 + \beta(T) + 2 \cdot \alpha(T) \cdot \beta(T)} - N_A \qquad (5)$$

$$n_0(T) = N_C(T) \cdot \exp\left(\frac{E_F - E_D}{kT}\right) \qquad (6)$$

dans lesquelles $N_A$ et $N_D$ sont les concentrations en dopants accepteurs et donneurs, $N_C$ est la densité d'états dans la bande de conduction, $E_F$ l'énergie du niveau de Fermi, $E_D$ le niveau d'énergie des dopants de type donneur, k la constante de Boltzmann et T la température de l'échantillon.

$\alpha(T)$ et $\beta(T)$ sont donnés par les expressions suivantes :

$$\alpha(T) = 0{,}5 \cdot \exp\left(\frac{E_2 - E_F(T)}{kT}\right),$$

et

$$\beta(T) = 2 \cdot \exp\left(\frac{E_1 - E_F(T)}{kT}\right),$$

où $E_1 = E_C$ - 70 meV et $E_2 = E_C$ - 150 meV.

On détermine la concentration en donneurs thermiques $N_{DDT}$ en faisant coïncider les courbes théoriques, issues des expressions (5) et (6), avec la courbe expérimentale $n_0(T)$ issue des mesures en température. Autrement dit, on fait varier numériquement les valeurs de $N_A$, $N_D$ et $N_{DDT}$ des équations (5) et (6) jusqu'à ce que les courbes théoriques se superposent au relevé de mesure $n_0(T)$.

De nombreuses variantes et modifications du procédé de détermination décrit ici apparaîtront à l'homme du métier. Le procédé a été décrit en relation avec un substrat de silicium. Toutefois, le procédé peut être également appliqué aux autres semi-conducteurs du groupe IV, notamment des substrats de germanium ou de silicium-germanium. En effet, le germanium est également un semi-conducteur dans lequel des donneurs thermiques peuvent être formés en présence d'oxygène.

## Revendications

1. Procédé de détermination de la concentration en oxygène interstitiel ($C_o$) d'un échantillon en matériau semi-conducteur du groupe IV et de type $p_1$ comprenant des impuretés dopantes de type accepteur et présentant une concentration initiale en porteurs de charge ($p_0$) et une résistivité initiale ($\rho_o$), comportant l'étape suivante :

   a) soumettre (F1) l'échantillon à un traitement thermique pour former des donneurs thermiques (DDT) constituant des impuretés dopantes de type donneur ;
   b) déterminer (F1) la durée du traitement thermique (t) nécessaire pour obtenir un matériau semi-conducteur compensé en impuretés dopantes ;
   c) déterminer (F2) la concentration en donneurs thermiques ($N_{DDT}$) de l'échantillon en matériau semi-conducteur compensé, à partir de la concentration en porteurs de charge (p, $p_0$) ; et
   d) déterminer (F3) la concentration en oxygène interstitiel ($C_o$) à partir de la concentration en donneurs thermiques ($N_{DDT}$) et de la durée du traitement thermique (t).

2. Procédé selon la revendication 1, dans lequel la concentration en donneurs thermiques ($N_{DDT}$) est déterminée à partir de la concentration initiale en porteurs de charge ($p_0$).

3. Procédé selon la revendication 2, dans lequel la concentration en donneurs thermiques $N_{DDT}$ est calculée à partir de la concentration initiale en porteurs de charge $p_0$ à l'aide de la relation suivante :

$$N_{DDT} = \frac{p_0}{2}.$$

4. Procédé selon la revendication 1, dans lequel la concentration en donneurs thermiques ($N_{DDT}$) est déterminée à partir de la concentration en porteurs de charge ($n_0$) mesurée après que l'échantillon soit passé d'une conductivité de type p à une conductivité de type n.

5. Procédé selon l'une quelconque des revendications 1 à 4, dans lequel l'étape b) comporte les étapes suivantes :

   i) réaliser (F11) le traitement thermique pendant une période de temps ($t_i$),
   ii) mesurer (F12) la résistivité (ρ) de l'échantillon,
   iii) répéter les étapes i) et ii) jusqu'à ce que la résistivité de l'échantillon dépasse une valeur seuil ($\rho_m$).

6. Procédé selon la revendication 5, dans lequel la valeur seuil ($\rho_m$) est supérieure à 200 Ω.cm et supérieure à deux fois la résistivité initiale ($\rho_o$) de l'échantillon.

7. Procédé selon l'une quelconque des revendications 1 à 4, dans lequel l'étape b) comporte les étapes suivantes :

   i) réaliser (F11) le traitement thermique pendant une période de temps ($t_i$),
   ii) mesurer (F12) le type de conductivité de l'échantillon,
   iii) répéter les étapes i) et ii) tant que l'échantillon a une conductivité de type p.

8. Procédé selon la revendication 7, dans lequel la mesure du type de conductivité est réalisée par une mesure de potentiel de surface de l'échantillon.

9. Procédé selon l'une quelconque des revendications 1 à 8, comprenant initialement une étape (F0) de traitement thermique à une température supérieure ou égale à 650°C et une étape (F0') de détermination de la concentration initiale en porteurs de charge ($p_0$).

10. Procédé selon la revendication 9, dans lequel la concentration initiale en porteurs de charge ($p_0$) est déterminée par une mesure de résistivité lorsque l'échantillon comprend des impuretés dopantes de type donneur en concentration ($N_D$) inférieure à un cinquième de la concentration en impuretés dopantes de type accepteur ($N_A$).

11. Procédé selon la revendication 9, dans lequel la concentration initiale en porteurs de charge ($p_0$) est mesurée par effet Hall ou par spectrométrie d'absorption lorsque l'échantillon comprend des impuretés dopantes de type donneur en concentration ($N_D$) supérieure à un cinquième de la concentration en impuretés dopantes de type accepteur ($N_A$).

12. Procédé selon l'une quelconque des revendications 1 à 11, comprenant, après avoir déterminé la concentration en oxygène interstitiel ($C_o$), une étape (F4) de traitement thermique à une température supérieure ou égale à 650°C.

13. Procédé selon l'une quelconque des revendications 1 à 12, **caractérisé en ce que** les étapes a) à d) sont réalisées en plusieurs zones de l'échantillon de façon à constituer une cartographie.

## Patentansprüche

1. Verfahren zur Bestimmung der interstitiellen Sauerstoffkonzentration ($C_o$) einer Probe aus Halbleitermaterial der Gruppe IV und vom Typ p, welche Dotierungsverunreinigungen vom Akzeptortyp enthält und eine Ausgangskonzentration von Ladungsträgern ($p_0$) sowie einen spezifischen Ausgangswiderstand ($\rho_0$) aufweist, mit dem folgenden Schritt:

a) Unterziehen (F1) der Probe einer Wärmebehandlung zur Bildung von thermischen Donatoren (DDT), welche Dotierungsverunreinigungen vom Donatortyp darstellen;
b) Bestimmen (F1) der Dauer der Wärmebehandlung (t), die zur Gewinnung eines in Dotierungsverunreinigungen ausgeglichenen Halbleitermaterials erforderlich ist,
c) Bestimmen (F2) der Konzentration von thermischen Donatoren ($N_{DDT}$) der Probe aus ausgeglichenem Halbleitermaterial ausgehend von der Konzentration von Ladungsträgern (p, $p_0$); und
d) Bestimmen (F3) der Konzentration von interstitiellem Sauerstoff ($C_o$) ausgehend von der Konzentration von thermischen Donatoren ($N_{DDT}$) und von der Dauer der Wärmebehandlung (t).

**2.** Verfahren nach Anspruch 1, wobei die Konzentration von thermischen Donatoren ($N_{DDT}$) aus der Ausgangskonzentration von Ladungsträgern ($p_0$) bestimmt wird.

**3.** Verfahren nach Anspruch 2, wobei die Konzentration von thermischen Donatoren $N_{DDT}$ aus der Ausgangskonzentration von Ladungsträgern $p_0$ mit Hilfe der folgenden Beziehung berechnet wird:

$$N_{DDT} = \frac{p_0}{2}.$$

**4.** Verfahren nach Anspruch 1, wobei die Konzentration von thermischen Donatoren ($N_{DDT}$) aus der Konzentration von Ladungsträgern ($n_0$) bestimmt wird, welche nach dem Übergang der Probe von einer Leitfähigkeit vom Typ p in eine Leitfähigkeit vom Typ n gemessen wird.

**5.** Verfahren nach einem der Ansprüche 1 bis 4, wobei der Schritt b) die folgenden Schritte umfasst:

i) Durchführen (F11) der Wärmebehandlung während eines Zeitraumes ($t_i$),
ii) Messen (F12) des spezifischen Widerstandes ($\rho$) der Probe,
iii) Wiederholen der Schritte i) und ii), bis der spezifische Widerstand der Probe einen Schwellenwert ($\rho_m$) überschreitet.

**6.** Verfahren nach Anspruch 5, wobei der Schwellenwert ($\rho_m$) größer als 200 Ω.cm und größer als der zweifache spezifische Ausgangswiderstand ($\rho_0$) der Probe ist.

**7.** Verfahren nach einem der Ansprüche 1 bis 4, wobei der Schritt b) die folgenden Schritte umfasst:

i) Durchführen (F11) der Wärmebehandlung während eines Zeitraumes ($t_i$),
ii) Messen (F12) des Leitfähigkeitstyps der Probe,
iii) Wiederholen der Schritte i) und ii), solange die Probe eine Leitfähigkeit vom Typ p aufweist.

**8.** Verfahren nach Anspruch 7, wobei die Messung des Leitfähigkeitstyps durch eine Messung des Oberflächenpotentials der Probe erfolgt.

**9.** Verfahren nach einem der Ansprüche 1 bis 8, mit zunächst einem Schritt (F0) einer Wärmebehandlung mit einer Temperatur, die höher als oder gleich 650°C ist, und einem Schritt (F0') der Bestimmung der Ausgangskonzentration von Ladungsträgern ($p_0$).

**10.** Verfahren nach Anspruch 9, wobei die Ausgangskonzentration von Ladungsträgern ($p_0$) durch eine Widerstandsmessung bestimmt wird, wenn die Probe Dotierungsverunreinigungen vom Donatortyp in einer Konzentration ($N_D$) enthält, die geringer als ein Fünftel der Konzentration von Dotierungsverunreinigungen vom Akzeptortyp ($N_A$) ist.

**11.** Verfahren nach Anspruch 9, wobei die Ausgangskonzentration von Ladungsträgern ($p_0$) durch den Hall-Effekt oder die Absorptions-Spektrometrie gemessen wird, wenn die Probe Dotierungsverunreinigungen vom Donatortyp in einer Konzentration ($N_D$) enthält, die größer als ein Fünftel der Konzentration von Dotierungsverunreinigungen vom Akzeptortyp ($N_A$) ist.

**12.** Verfahren nach einem der Ansprüche 1 bis 11, das nach der Bestimmung der Konzentration von interstitiellem Sauerstoff ($C_o$) einen Schritt (F4) einer Wärmebehandlung mit einer Temperatur umfasst, die höher als oder gleich 650°C ist.

**13.** Verfahren nach einem der Ansprüche 1 bis 12, **dadurch gekennzeichnet, dass** die Schritte a) bis d) in mehreren Bereichen der Probe derart durchgeführt werden, dass sie eine Kartographie bilden.

## Claims

**1.** Method for determining the interstitial oxygen concentration ($C_o$) of a sample made from a group-IV p-type semiconductor material, comprising acceptor-type dopant impurities and having an initial charge carrier concentration ($p_0$) and an initial resistivity ($\rho_o$), comprising the step of:

a) submitting (F1) the sample to a heat treatment to form thermal donors (TDD) forming donor-type dopant impurities,
b) determining (F1) the duration (t) of the heat treatment required to obtain a dopant impurity-compensated semiconductor material;
c) determining (F2) the thermal donor concentration ($N_{TDD}$) of the sample of compensated semiconductor material from the charge carrier concentration (p, $p_0$); and
d) determining (F3) the interstitial oxygen concentration ($C_o$) from the thermal donor concentration ($N_{TDD}$) and the duration (t) of the heat treatment.

**2.** Method according to claim 1, wherein the thermal donor concentration ($N_{TDD}$) is determined from the initial charge carrier concentration ($p_0$).

**3.** Method according to claim 2, wherein the thermal donor concentration $N_{TDD}$ is determined from the initial charge carrier concentration $p_0$ by means of the following relation:

$$N_{TDD} = \frac{p_0}{2}.$$

**4.** Method according to claim 1, wherein the thermal donor concentration ($N_{TDD}$) is determined from the charge carrier concentration ($n_0$) measured after the sample has passed from a p-type conductivity to an n-type conductivity.

**5.** Method according to any one of claims 1 to 4, wherein step b) comprises the steps of:

i) carrying out (F11) the heat treatment for a time period ($t_i$),
ii) measuring (F12) the resistivity ($\rho$) of the sample,
iii) repeating steps i) and ii) until the resistivity of the sample exceeds a threshold value ($\rho_m$).

**6.** Method according to claim 5, wherein the threshold value ($\rho_m$) is greater than 200 Ω.cm and greater than twice the initial resistivity ($\rho_o$) of the sample.

**7.** Method according to any of one claims 1 to 4, wherein step b) comprises the steps of:

i) carrying out (F11) the heat treatment for a time period ($t_i$),
ii) measuring (F12) the conductivity type of the sample,
iii) repeating steps i) and ii) as long as the sample has a p-type conductivity.

**8.** Method according to claim 7, wherein the measurement of the conductivity type is performed by a measurement of the surface photo voltage of the sample.

**9.** Method according to any one of claims 1 to 8, initially comprising a heat treatment step (F0) at a temperature greater than or equal to 650 °C and a step (F0') of determining the initial charge carrier concentration ($p_0$).

**10.** Method according to claim 9, wherein the initial charge carrier concentration ($p_0$) is determined by a resistivity measurement when the sample comprises donor-type dopant impurities by a concentration ($N_D$) smaller than one fifth of the concentration of acceptor-type dopant impurities ($N_A$).

**11.** Method according to claim 9, wherein the initial charge carrier concentration ($p_0$) is measured by Hall effect or by absorption spectrometry when the sample comprises donor-type dopant impurities by a concentration ($N_D$) greater than one fifth of the concentration of acceptor-type dopant impurities ($N_A$).

**12.** Method according to any one of claims 1 to 11, comprising, after having determined the interstitial oxygen concentration ($C_o$), a step (F4) of heat treatment at a temperature greater than or equal to 650 °C.

**13.** Method according to any one of claims 1 to 12, **characterized in** the steps a) to d) are carried out in several areas of the sample to perform a mapping.

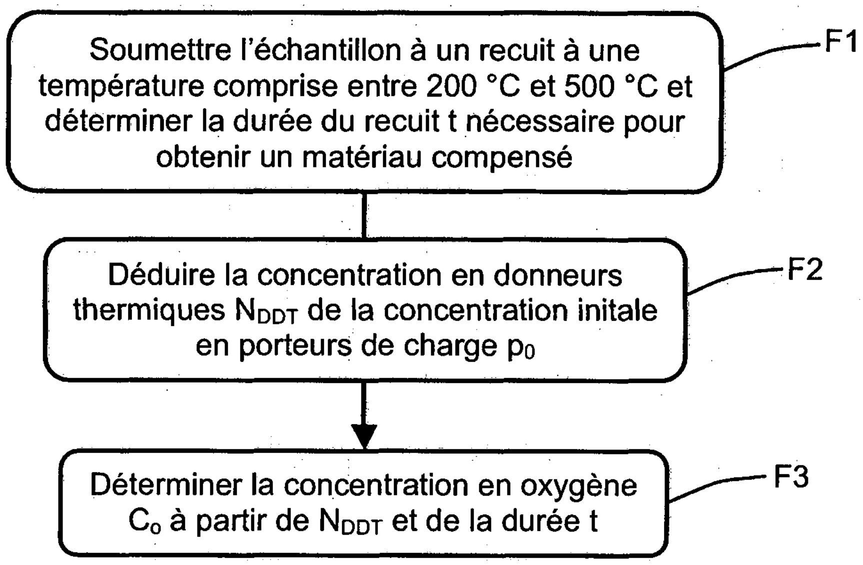
Soumettre l'échantillon à un recuit à une température comprise entre 200 °C et 500 °C et déterminer la durée du recuit t nécessaire pour obtenir un matériau compensé
F1
Déduire la concentration en donneurs thermiques $N_{DDT}$ de la concentration initale en porteurs de charge $p_0$
F2
Déterminer la concentration en oxygène $C_o$ à partir de $N_{DDT}$ et de la durée t
F3

Fig. 1

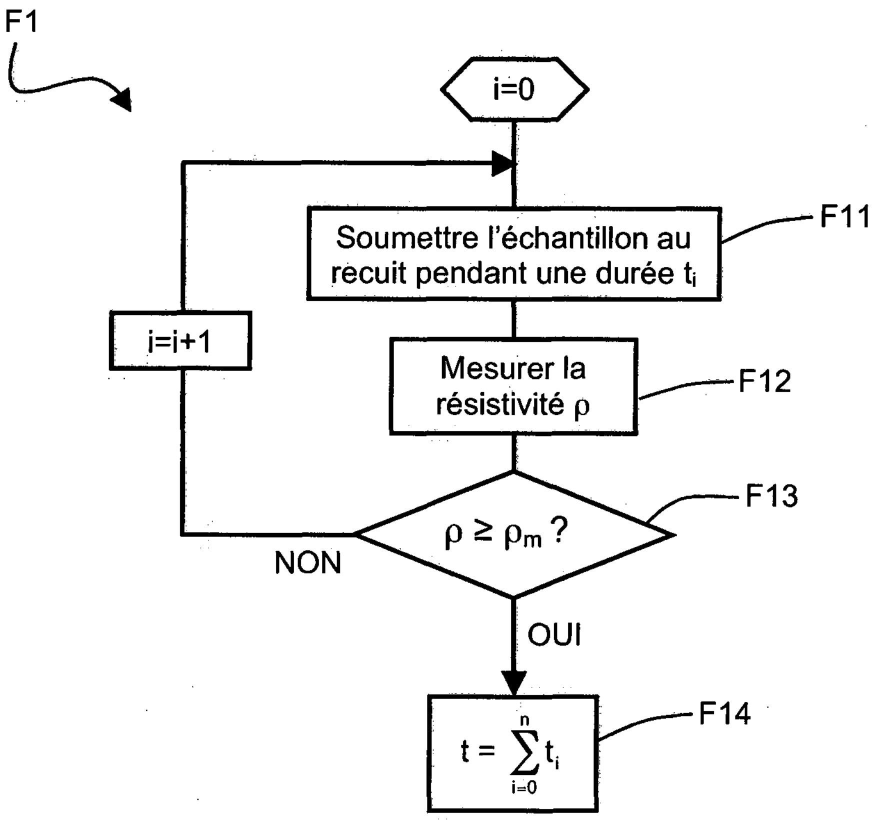
F1
i=0
Soumettre l'échantillon au recuit pendant une durée $t_i$
F11
i=i+1
Mesurer la résistivité ρ
F12
$\rho \geq \rho_m$ ?
F13
NON
OUI
$t = \sum_{i=0}^{n} t_i$
F14

Fig. 2

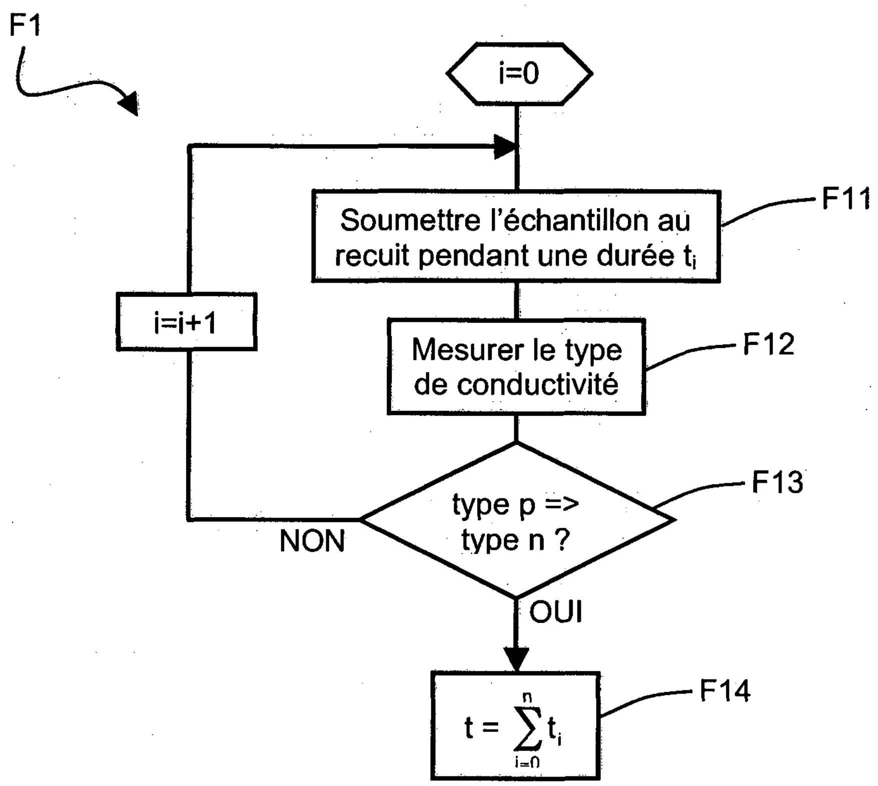
F1
i=0
Soumettre l'échantillon au recuit pendant une durée $t_i$
F11
i=i+1
Mesurer le type de conductivité
F12
type p => type n ?
F13
NON
OUI
$t = \sum_{i=0}^{n} t_i$
F14

Fig. 3

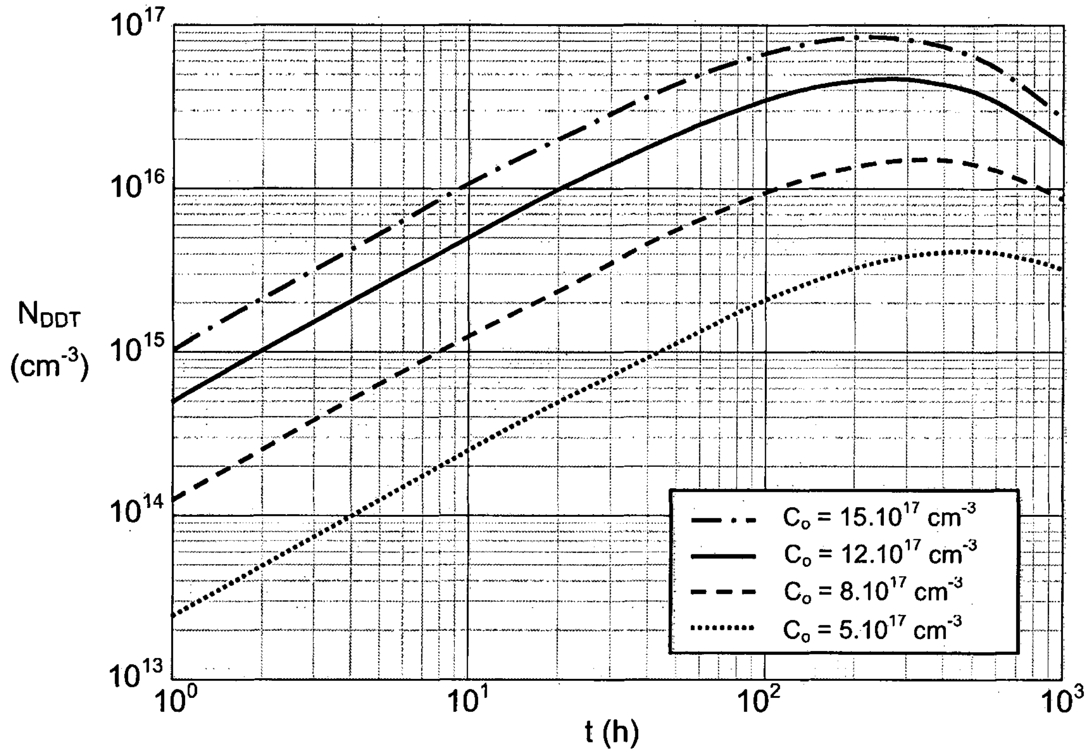
$N_{DDT}$ ($cm^{-3}$)
$10^{17}$
$10^{16}$
$10^{15}$
$10^{14}$
$10^{13}$
$10^0$
$10^1$
$10^2$
$10^3$
t (h)
$C_o = 15.10^{17}\ cm^{-3}$
$C_o = 12.10^{17}\ cm^{-3}$
$C_o = 8.10^{17}\ cm^{-3}$
$C_o = 5.10^{17}\ cm^{-3}$

Fig. 4

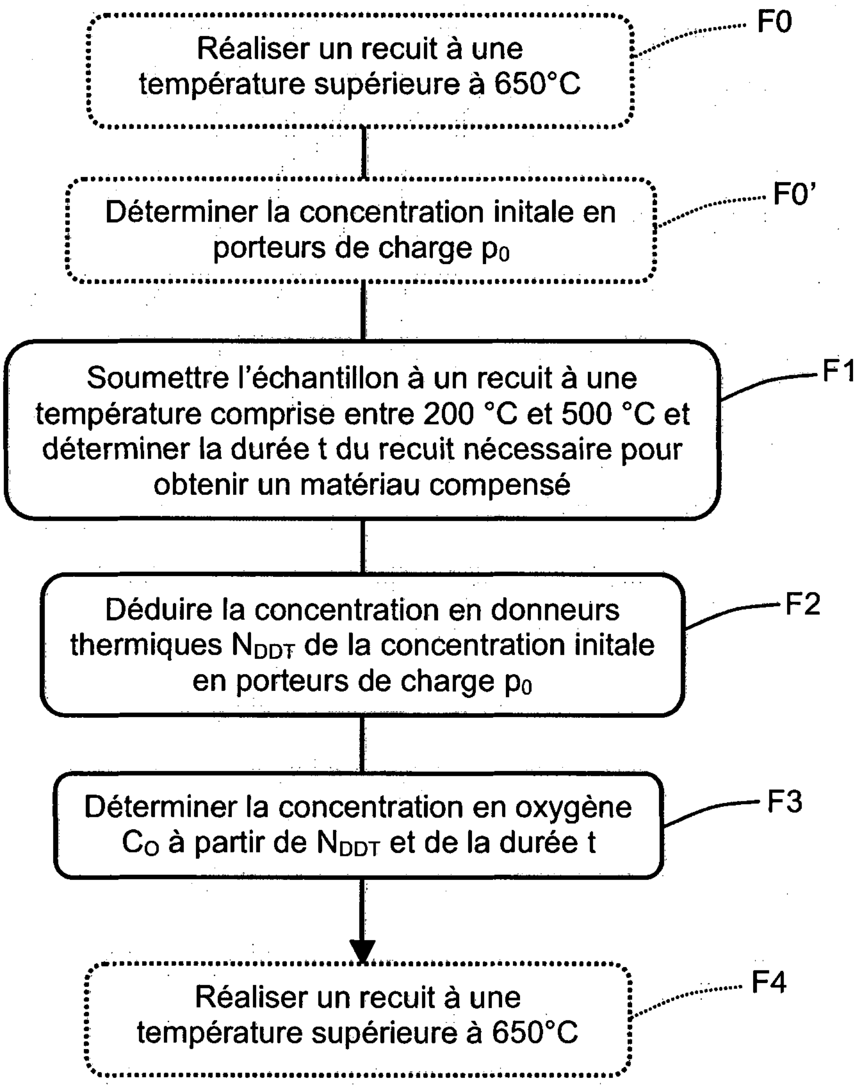
Réaliser un recuit à une température supérieure à 650°C
F0
Déterminer la concentration initale en porteurs de charge p0
F0'
Soumettre l'échantillon à un recuit à une température comprise entre 200 °C et 500 °C et déterminer la durée t du recuit nécessaire pour obtenir un matériau compensé
F1
Déduire la concentration en donneurs thermiques NDDT de la concentration initale en porteurs de charge p0
F2
Déterminer la concentration en oxygène CO à partir de NDDT et de la durée t
F3
Réaliser un recuit à une température supérieure à 650°C
F4

Fig. 5

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description


- FR 246479


### Littérature non-brevet citée dans la description


- **A.G. ULYASHIN et al.** *Materials Science and Engineering,* 2000, vol. B73, 124-129
- **WIJARANAKULA C.A. et al.** *Appl. Phys. Lett.,* vol. 59 (13), 1608, , 1991
- **LONDOS C.A. et al.** *Appl. Phys. Lett.,* vol. 62 (13), 1525, , 1993